# EUROPEAN PATENT SPECIFICATION

(11) **EP 3 839 593 B1**
(45) Date of publication and mention of the grant of the patent: **19.07.2023**
(21) Application number: 19216831.8
(22) Date of filing: 17.12.2019
(51) Int. Cl.: G02B 17/08, G02B 19/00, G02B 27/30, F21V 5/00, F21V 5/04, F21V 7/00, H01L 33/58, F21Y 115/10, F21Y 103/10

(54) **LENS DEVICE**
LINSENVORRICHTUNG
DISPOSITIF DE LENTILLE

(43) Date of publication of application: 23.06.2021
(73) Proprietor: T.Y.C. Brother Industrial Co., Ltd., 70248 Tainan City (TW)
(72) Inventor: SHIH, Ming-Chih, 70248 Tainan City (TW)
(74) Representative: Style, Kelda Camilla Karen

(56) References cited:
- EP-A1- 1 962 013
- CN-A- 104 676 482
- US-A- 2 254 962
- US-A- 5 757 557
- US-A1- 2010 110 695
- US-A1- 2010 128 233

## Description

The disclosure relates to a lens device, more particularly to a lens device for distribution of light beams from a light emitter.

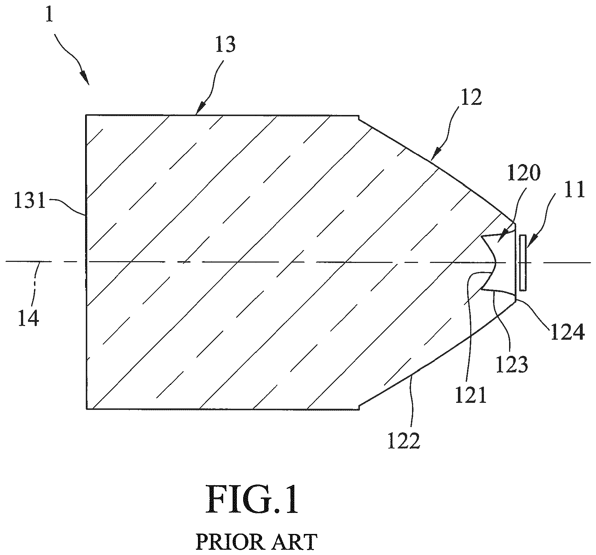

As shown in Fig. 1, a conventional vehicle lighting assembly may include at least one optical lens 1 and a light emitter 11 which is disposed rearwardly of the optical lens 1 and which has an emitter axis 14 in a front-rear direction. The optical lens 1 includes a rear lens segment 12 and a front lens segment 13.

The rear lens segment 12 has a recess 120 and a reflective surface 122. The recess 120 extends forwardly from a rear end 124 of the rear lens segment 12 along the emitter axis 14 to terminate at a first refractive surface 121. The recess 120 has a second refractive surface 123 which extends in the front-rear direction to interconnect the rear end 124 and the first refractive surface 121, and which extends circumferentially to surround the emitter axis 14. The reflective surface 122 diverges forwardly from an outer periphery of the rear end 124 to surround the emitter axis 14 and to form an outer peripheral surface of the rear lens segment 12. The front lens segment 13 extends forwardly from the rear lens segment 12 along the emitter axis 14 to terminate at a lens front 131 with a flat profile.

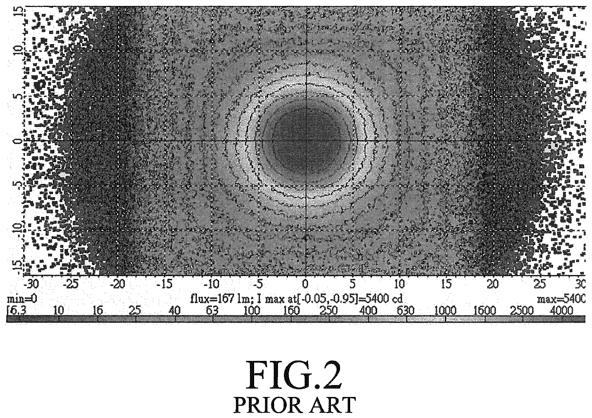

The light beams from the light emitter 11 entering the optical lens 1 through the first refractive surface 121 may leave the optical lens 1 from the lens front 131. The light beams from the light emitter 11 entering the optical lens 1 through the second refractive surface 123 may be reflected by the reflective surface 122 and then may leave the optical lens 1 through the lens front 131. The outputted light beams from the optical lens 1 may have a light distribution pattern shown in Fig. 2.

Recently, it is required for the lens front 131 of the optical lens 1 to have a convex profile. There is thus a need to provide an optical lens with a convex lens front, and from which the outputted light beams have a light distribution pattern similar to that shown in Fig. 2.

Therefore, an object of the disclosure is to provide a novel lens device which has at least one optical lens with a convex lens front. The outputted light beams from the novel lens device may have a light distribution pattern similar to that shown in Fig. 2.

US5757557A discloses a device for directing light longitudinally forwardly, that comprises a lens body having a front face facing forwardly, rearward body extent, and a curved sidewall extending between the rearward body extent and the front face; a rear cavity in the body, the cavity having a sidewall and a front wall defining a corner; and a light source in the cavity, and characterized in that light rays transmitted by the light source toward the curved sidewall, and toward the corner are collimated forwardly.

The invention is defined by the independent claims. Preferred embodiments are set out in the dependent claims.

According to the disclosure, a lens device is provided for directing light beams from a light emitter which has an emitter axis in a front-rear direction. The lens device includes at least one optical lens which includes a rear lens segment and a front lens segment. The rear lens segment has a recess and a reflective surface. The recess extends forwardly from a rear end of the rear lens segment along the emitter axis to terminate at a first refractive surface. The recess has a second refractive surface which extends in the front-rear direction to interconnect the rear end and the first refractive surface, and which extends circumferentially to surround the emitter axis. The reflective surface diverges forwardly from an outer periphery of the rear end to surround the emitter axis and to form an outer peripheral surface of the rear lens segment. The front lens segment extends forwardly from the rear lens segment along the emitter axis to terminate at a convex lens front which defines a rear focal region located rearwardly of the rear lens segment. The first refractive surface is configured such that when the light beams from the light emitter enter the optical lens through the first refractive surface to form a plurality of first refracted light beams in the optical lens, a plurality of first imaginary lines, which extend rearwardly and respectively from the first refracted light beams, converge at a first focal region. The second refractive surface and the reflective surface are configured such that when the light beams from the light emitter enter the optical lens through the second refractive surface and then are reflected by the reflective surface to form a plurality of reflected light beams, a plurality of second imaginary lines, which extend rearwardly and respectively from the reflected light beams, converge at a second focal region overlapping with the rear focal region.

Other features and advantages of the disclosure will become apparent in the following detailed description of the embodiment (s) with reference to the accompanying drawings, in which:
Fig. 1 is a partially cross-sectional view illustrating a conventional vehicle lighting assembly;
Fig. 2 is a light distribution pattern of light beams outputted from the conventional vehicle lighting assembly;
Fig. 3 is a front perspective view of a lighting assembly according to a first embodiment of the disclosure;
Fig. 4 is a rear perspective view of the first embodiment in which light emitters are omitted;
Fig. 5 is a partially cross-sectional view taken in the YZ plane of the first embodiment;
Fig. 6 is another partially cross-sectional view taken in the XZ plane of the first embodiment;
Fig. 7 is similar to Fig. 5 but is further illustrated with light beams from a light emitter entering an optical lens through a first refractive surface;
Fig. 8 is similar to Fig. 7 but is further illustrated with the light beams from the light emitter entering the optical lens through a second refractive surface;
Fig. 9 is similar to Fig. 8 but is further illustrated with the light beams, refracted by the second refractive surface, being further reflected by a reflective surface;
Fig. 10 is a light distribution pattern of the light beams outputted from one of the optical lenses in the first embodiment;
Fig. 11 is a partially cross-sectional view taken in the XZ plane of a lighting assembly according to a second embodiment of the disclosure;
Fig. 12 is a light distribution pattern of the light beams outputted from the second embodiment;
Fig. 13 is a perspective view of a lighting assembly according to a third embodiment of the disclosure;
Fig. 14 is a partially cross-sectional view taken in the YZ plane of the third embodiment;
Fig. 15 is another partially cross-sectional view taken in the XZ plane of the third embodiment;
Fig. 16 is similar to Fig. 14 but is further illustrated with paths of the light beams in the YZ plane;
Fig. 17 is similar to Fig. 15 but is further illustrated with paths of the light beams in the XZ plane; and
Fig. 18 is a light distribution pattern of the light beams outputted from one of optical lenses in the third embodiment.

Before the disclosure is described in greater detail, it should be noted that where considered appropriate, reference numerals have been repeated among the figures to indicate corresponding or analogous elements, which may optionally have similar characteristics.

To aid in describing the disclosure, directional terms may be used in the specification and claims to describe portions of the present disclosure (e.g. , front, rear, left, right, top, bottom, etc.) . These directional definitions are intended to merely assist in describing and claiming the disclosure and are not intended to limit the disclosure in any way.

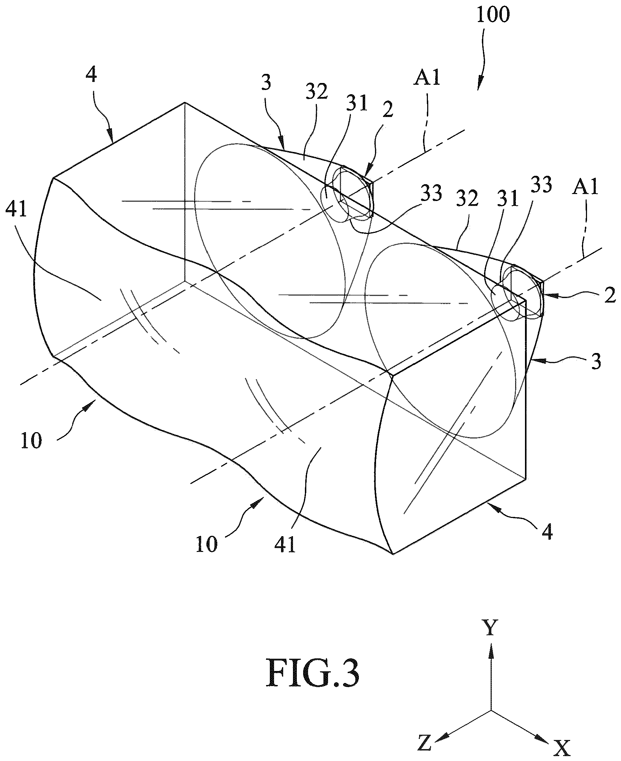

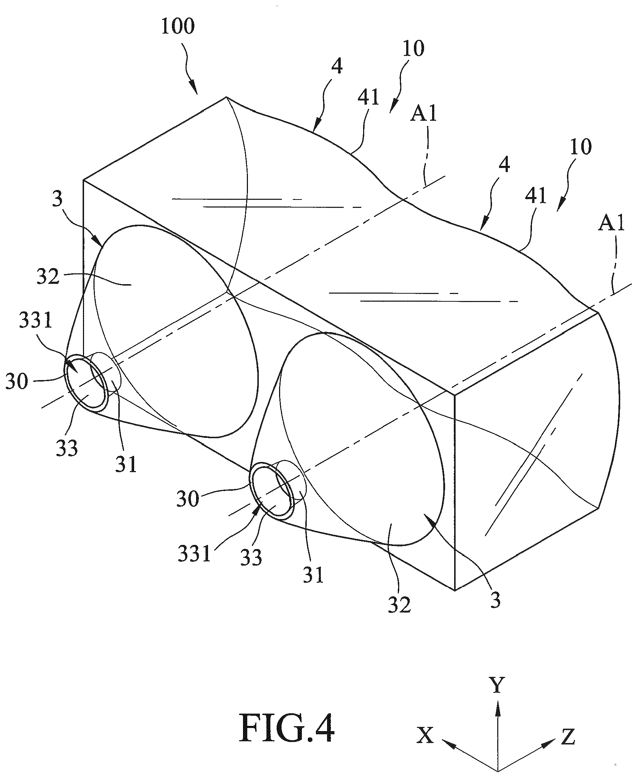

Referring to Figs. 3 and 4, a lighting assembly according to a first embodiment of the disclosure is shown to include a lens device 100 and at least one light emitter 2. The lens device 100 is provided for directing light beams from the light emitter 2 and includes at least one optical lens 10 which includes a rear lens segment 3 and a front lens segment 4. The light emitter 2 has an emitter axis (A1) in a front-rear direction (Z) . In an embodiment, the light emitter 2 may be a light-emitting diode chip, and the emitter axis (A1) may also serve as a symmetrical axis of the rear lens segment 3 of the optical lens 10.

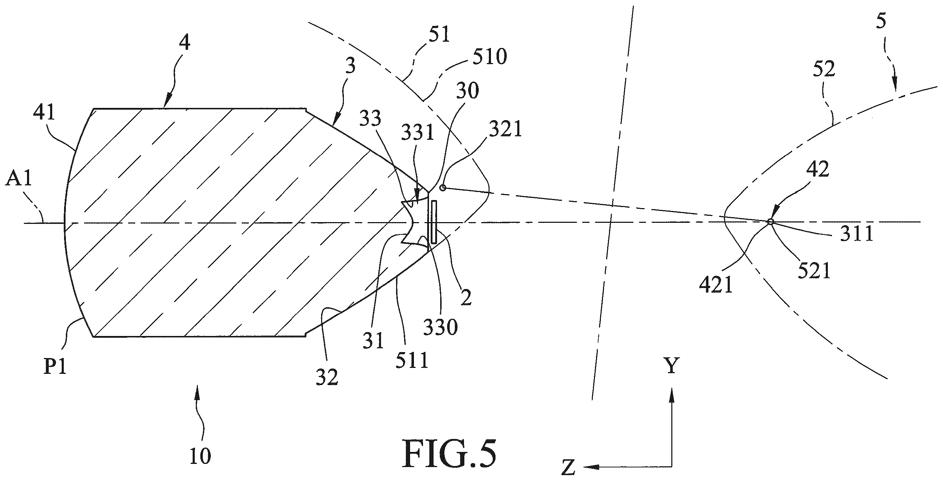

As shown in Figs. 4 and 5, the rear lens segment 3 has a recess 331 and a reflective surface 32. The recess 331 extends forwardly from a rear end 30 of the rear lens segment 3 along the emitter axis (A1) to terminate at a first refractive surface 31. The recess 331 has a second refractive surface 33 which extends in the front-rear direction (Z) to interconnect the rear end 30 and the first refractive surface 31, and which extends circumferentially to surround the emitter axis (A1) . The reflective surface 32 diverges forwardly from an outer periphery of the rear end 30 to surround the emitter axis (A1) and to form an outer peripheral surface of the rear lens segment 3.

The front lens segment 4 extends forwardly from the rear lens segment 3 along the emitter axis (A1) to terminate at a convex lens front 41 which defines a rear focal region 42 that is located rearwardly of the rear lens segment 3.

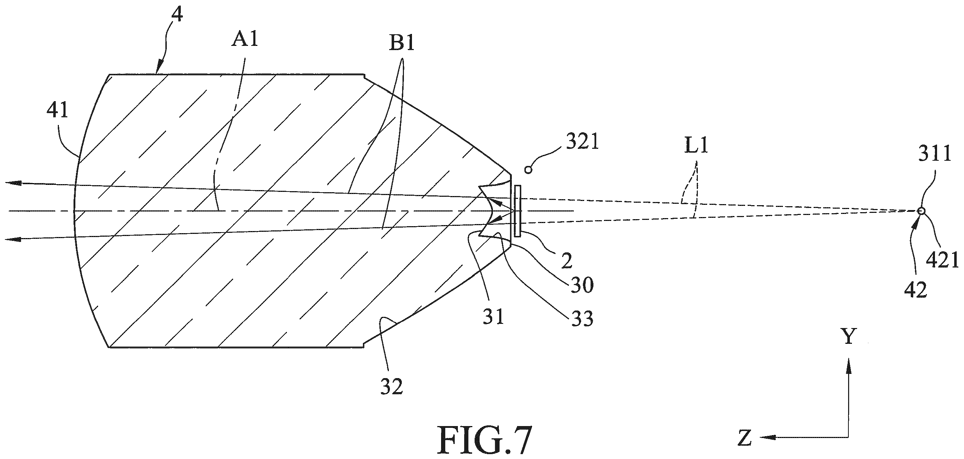

As shown in Fig. 7, the first refractive surface 31 is configured such that when the light beams from the light emitter 2 enter the optical lens 10 through the first refractive surface 31 to form a plurality of first refracted light beams (B1) in the optical lens 10, a plurality of first imaginary lines (L1), which extend rearwardly and respectively from the first refracted light beams (B1), converge at a first focal region 311 overlapping with the rear focal region 42.

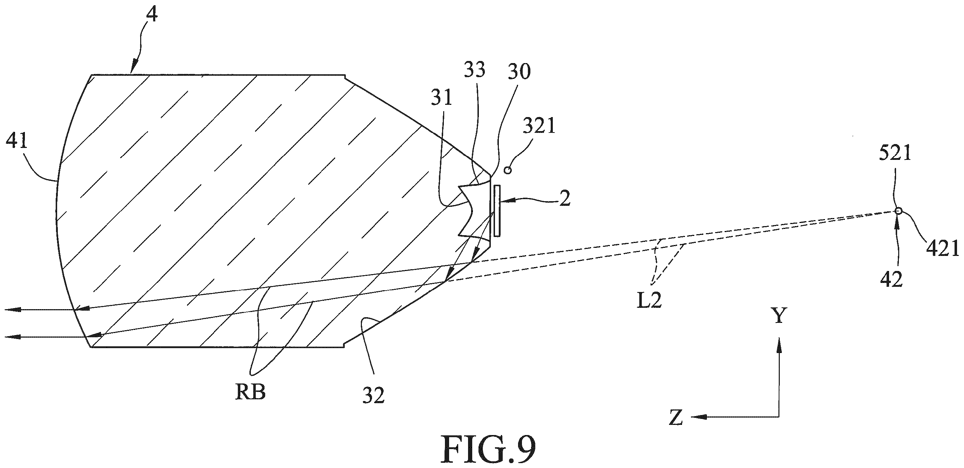

As shown in Fig. 9, the second refractive surface 33 and the reflective surface 32 are configured such that when the light beams from the light emitter 2 enter the optical lens 10 through the second refractive surface 33 and then are reflected by the reflective surface 32 to form a plurality of reflected light beams (RB), a plurality of second imaginary lines (L2), which extend rearwardly and respectively from the reflected light beams (RB), converge at a second focal region 521 overlapping with the rear focal region 42.

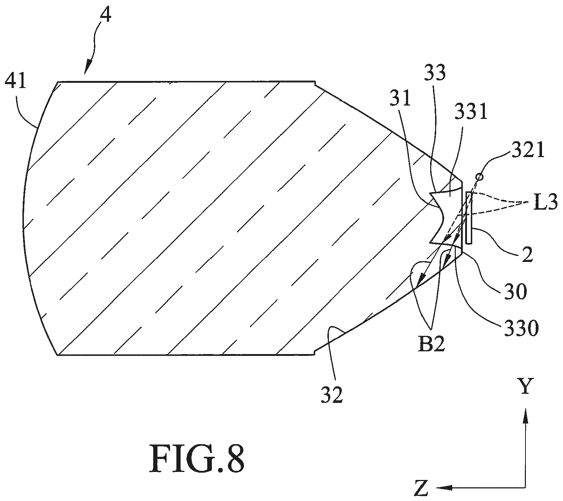

In an embodiment shown in Figs. 5 and 8, the rear focal region 42 has a rear focal point 421 on the emitter axis (A1). The second refractive surface 33 has a selected region 330 such that when the light beams from the light emitter 2 enter the optical lens 10 through the selected region 330 of the second refractive surface 33 to form a plurality of second refracted light beams (B2) in the optical lens 10, a plurality of third imaginary lines (L3), which extend rearwardly and respectively from the second refracted light beams (B2), converge at a third focal point 321.

Furthermore, the third focal point 321 and the rear focal point 421 of the rear focal region 42 cooperatively define a hyperbola 5 (see Fig. 5). The hyperbola 5 has a distal branch 52 and a proximal branch 51 relative to the third focal point 321. The proximal branch 51 has a distal arm 510 and a proximal arm 511 relative to the selected region 330 of the second refractive surface 33 . The reflective surface 32 is formed by rotating the proximal arm 511 about the emitter axis (A1).

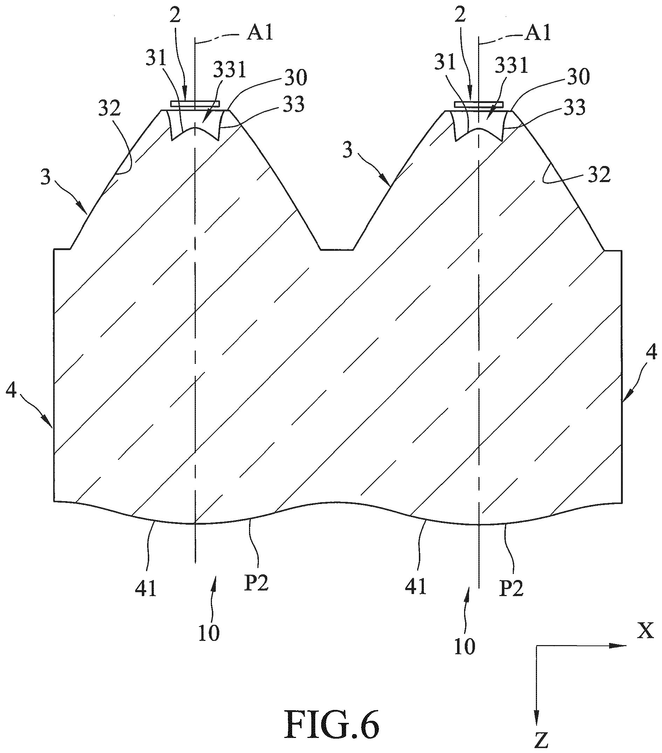

In an embodiment shown in Figs. 3, 5, and 6, the convex lens front 41 is a dome-shaped convex surface such that the rear focal region 42 is in the shape of a point at the rear focal point 421. In this case, the convex lens front 41 has a curved profile line (P1) in the YZ plane (see Fig. 5) and a curved profile line (P2) in the XZ plane (see Fig. 6).

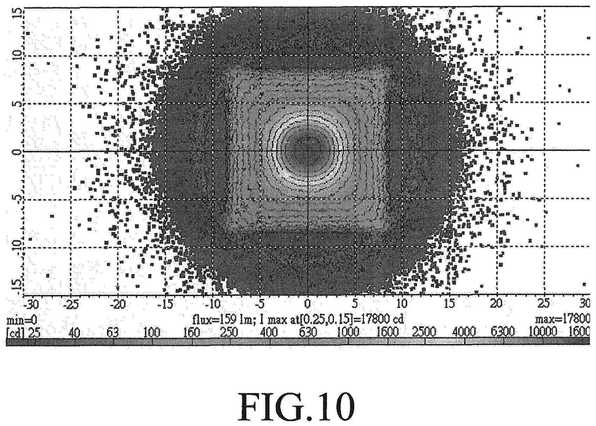

In an embodiment shown in Figs. 5, 7, and 9, each of the first and second focal regions 311, 521 is in the form of a point, and fully overlaps with the rear focal point 421. When a point of the light emitter 2 on the emitter axis (A1) has the coordinate (0,0,0) of an XYZ three-dimensional coordinate system, the coordinate of each of the first and second focal regions 311, 521 and the rear focal point 421 is (0,0, -20). In the xyz three-dimensional coordinate system, a unit is mm, and the x, y, z axes in the three-dimensional coordinate system are respectively in the X, Y, Z directions shown in Figs. 3 to 9. Please note that when each of the first and second focal regions 311, 521 fully overlaps with the rear focal point 421, the output light beams from the convex lens front 41 of the optical lens 10 are most likely substantially parallel to each other (see Figs. 7 and 9) and may have a light distribution pattern (Fig. 10) similar to that shown in Fig. 2.

In a non-shown embodiment, each of the first and second focal regions 311, 521 and the rear focal region 42 may be in the shape of a ball having a diameter ranging from 3 mm to 5 mm. Each of the first and second focal regions 311, 521 may partially or fully overlap with the rear focal region 42.

In an embodiment shown in Figs. 3, 4, and 6, the lighting assembly may include two of the light emitter 2 and the lens device 100 may include two of the optical lens 10. The front lens segments 4 of the optical lens 10 are integrally connected in the left-right direction (X) .

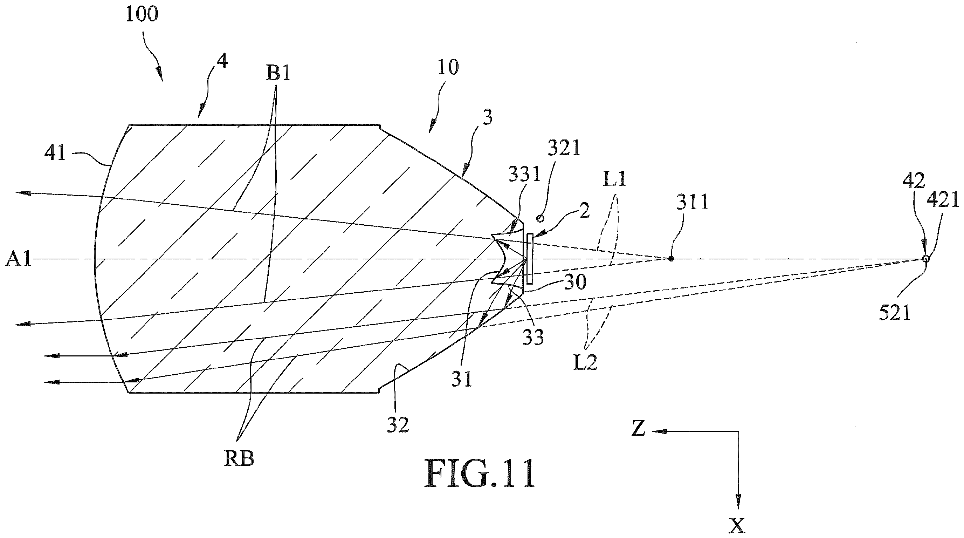

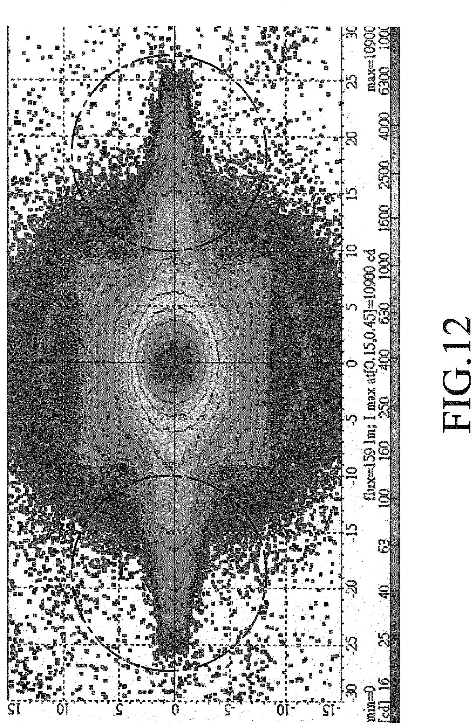

Fig. 11 illustrates a lighting assembly according to a second embodiment of the disclosure. The second embodiment is similar to the first embodiment except that in the second embodiment, the lens device 100 includes a single optical lens 10, and the first focal region 311 is located in front of the rear focal region 42. It can be found that when only the second focal region 521 overlaps with the rear focal region 42, the output light beams from the convex lens front 41 of the optical lens 10 may have a light distribution pattern (Fig. 12) which includes a central portion similar to the light distribution pattern shown in Fig. 2, and two additional lateral portions (marked respectively by two imaginary circles).

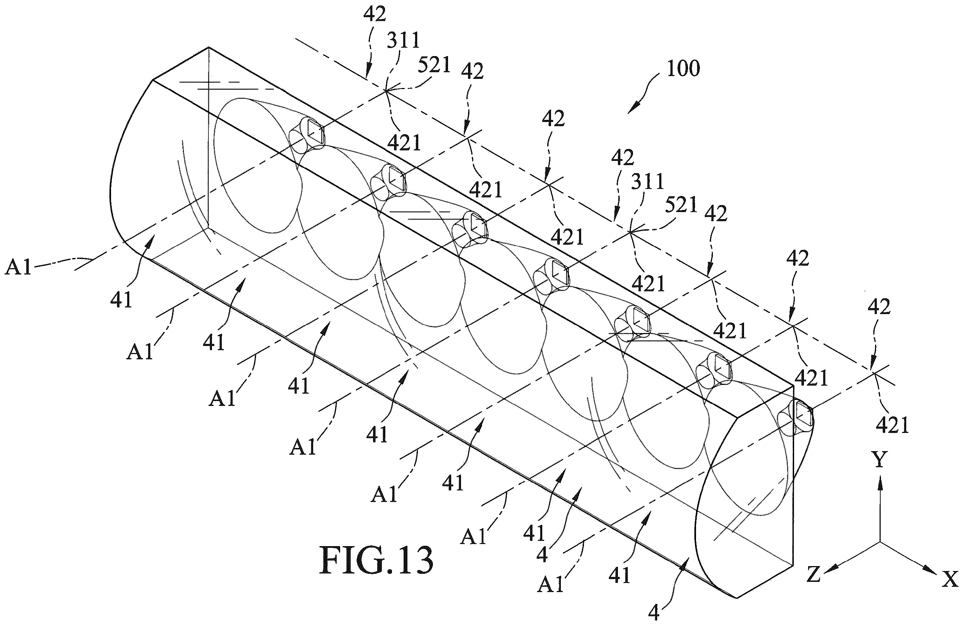

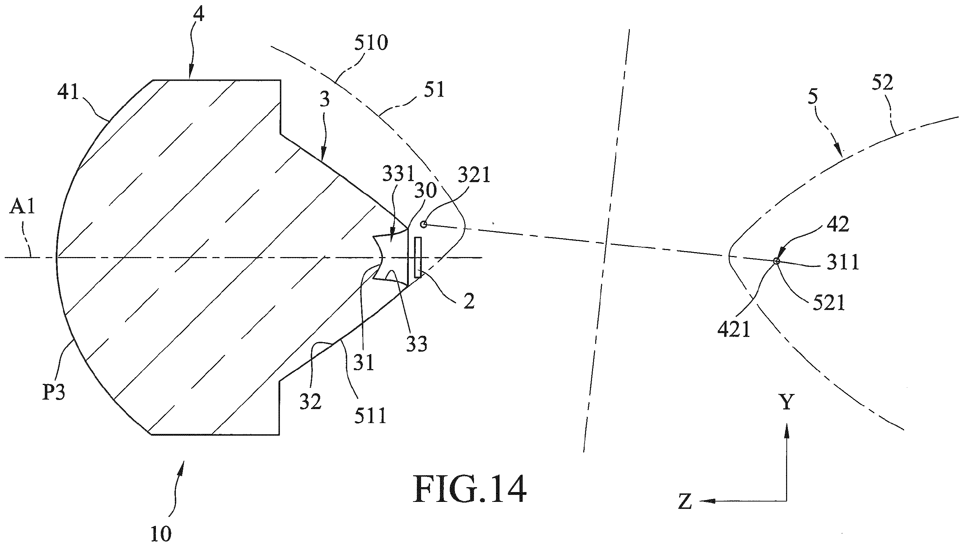

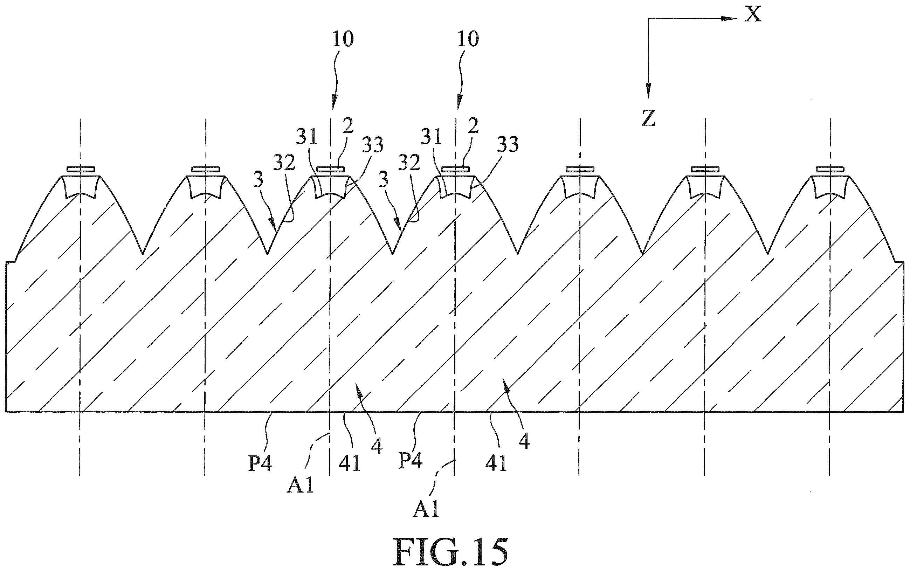

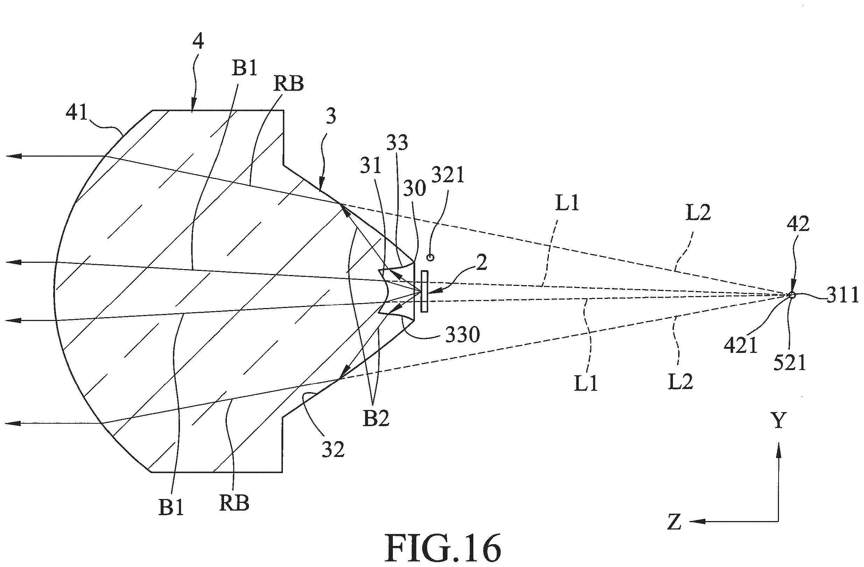

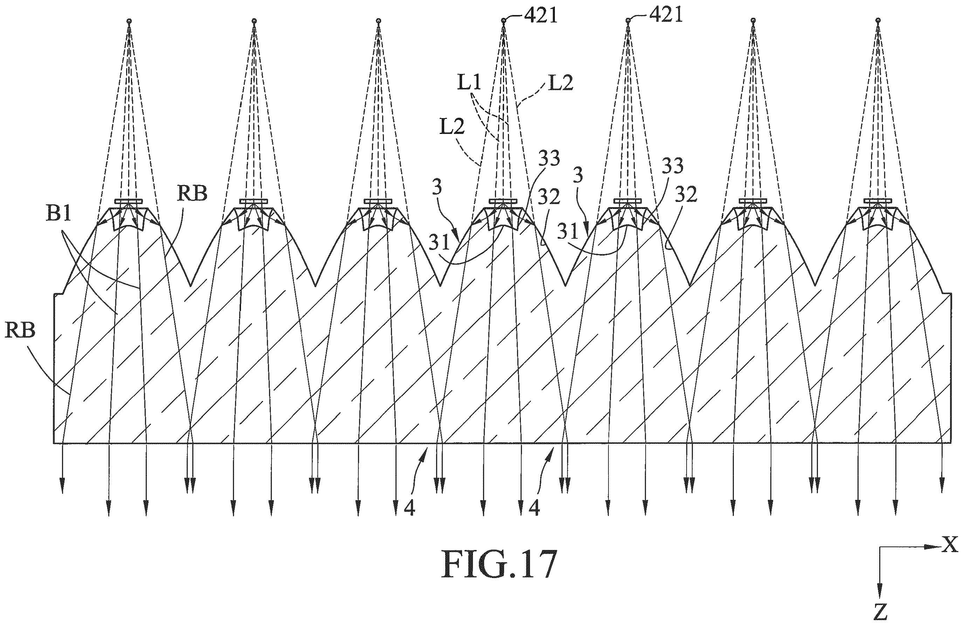

Figs. 13 to 17 illustrate a lighting assembly according to a third embodiment of the disclosure. The third embodiment is similar to the first embodiment except that in the third embodiment, the convex lens front 41 is an arch-shaped convex surface such that the rear focal region 42 is in the shape of a line in a left-right direction (X). The line 42 intersects the emitter axis (A1) at the rear focal point 421. In this case, the convex lens front 41 has a curved profile line (P3) in the YZ plane (see Fig. 14), and a straight profile line (P4) in the XZ plane (see Fig. 15).

In an embodiment shown in Figs. 13, each of the first and second focal regions 311, 521 is in the form of a point, and fully overlaps with the rear focal point 421.

In an embodiment shown in Figs. 13 to 17, the lens device 100 may include a plurality of the optical lenses 10 in which the front lens segments 4 thereof are integrally connected in the left-right direction (X).

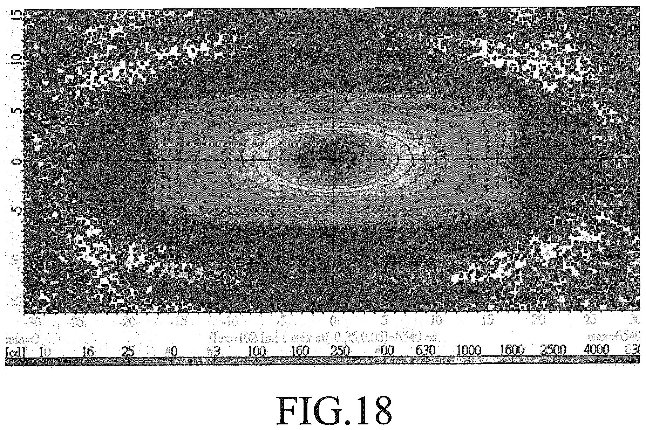

As shown in Fig. 18, the output light beams from the convex lens front 41 of the optical lens 10 may have a light distribution pattern similar to the light distribution pattern shown in Fig. 2.

In sum, when at least the second focal region 521 is devised to overlap with the rear focal region 42, each optical lens 10 with the convex lens front 41 may have a light distribution pattern similar to the light distribution pattern of the conventional optical lens with a flat lens front.

In the description above, for the purposes of explanation, numerous specific details have been set forth in order to provide a thorough understanding of the embodiment (s) . It will be apparent, however, to one skilled in the art, that one or more other embodiments may be practiced without some of these specific details. It should also be appreciated that reference throughout this specification to "one embodiment," "an embodiment, " an embodiment with an indication of an ordinal number and so forth means that a particular feature, structure, or characteristic may be included in the practice of the disclosure . It should be further appreciated that in the description, various features are sometimes grouped together in a single embodiment, figure, or description thereof for the purpose of streamlining the disclosure and aiding in the understanding of various inventive aspects, and that one or more features or specific details from one embodiment may be practiced together with one or more features or specific details from another embodiment, where appropriate, in the practice of the disclosure.

## Claims

1. A lens device (100) for directing light beams from a light emitter (2) which has an emitter axis (A1) in a front-rear direction (Z), said lens device (100) comprising at least one optical lens (10) which includes
a rear lens segment (3) having
a recess (331) extending forwardly from a rear end (30) of said rear lens segment (3) along the emitter axis (A1) to terminate at a first refractive surface (31), said recess (331) having a second refractive surface (33) which extends in the front-rear direction (Z) to interconnect said rear end (30) and said first refractive surface (31), and which extends circumferentially to surround the emitter axis (A1), and
a reflective surface (32) diverging forwardly from an outer periphery of said rear end (30) to surround the emitter axis (A1) and to form an outer peripheral surface of said rear lens segment (3); and
a front lens segment (4) extending forwardly from said rear lens segment (3) along the emitter axis (A1) to terminate at a convex lens front (41) which defines a rear focal region (42) that is located rearwardly of said rear lens segment (3),
said first refractive surface (31) is configured such that when the light beams from the light emitter (2) enter said optical lens (10) through said first refractive surface (31) to form a plurality of first refracted light beams (B1) in said optical lens (10), a plurality of first imaginary lines (L1), which extend rearwardly and respectively from the first refracted light beams (B1), converge at a first focal region (311);
said second refractive surface (33) and said reflective surface (32) are configured such that when the light beams from the light emitter (2) enter said optical lens (10) through said second refractive surface (33) and then are reflected by said reflective surface (32) to form a plurality of reflected light beams (RB), a plurality of second imaginary lines (L2), which extend rearwardly and respectively from the reflected light beams (RB), converge at a second focal region (521) overlapping with said rear focal region (42);
said first focal region (311) overlaps with said rear focal region (42);
said rear focal region (42) has a rear focal point (421) on the emitter axis (A1);
said second refractive surface (33) has a selected region (330) such that when the light beams from the light emitter (2) enter said optical lens (10) through said selected region (330) of said second refractive surface (33) to form a plurality of second refracted light beams (B2) in said optical lens (10), a plurality of third imaginary lines (L3), which extend rearwardly and respectively from the second refracted light beams (B2), converge at a third focal point (321);
said third focal point (321) and said rear focal point (421) of said rear focal region (42) cooperatively define a hyperbola (5) which has a distal branch (52) and a proximal branch (51) relative to said third focal point (321), the proximal branch (51) having a distal arm (510) and a proximal arm (511) relative to said selected region (330) of said second refractive surface (33); and
**characterized in that** said reflective surface (32) is formed by rotating the proximal arm (511) about the emitter axis (A1).

2. The lens device (100) according to claim 1, **characterized in that** said convex lens front (41) is a dome-shaped convex surface such that said rear focal region (42) is in the shape of a point or a ball at said rear focal point (421).

3. The lens device (100) according to claim 2, **characterized in that** each of said first and second focal regions (311, 521) is in the form of a point, and fully overlaps with said rear focal point (421).

4. The lens device (100) according to claim 1, **characterized in that** said convex lens front (41) is an arch-shaped convex surface such that said rear focal region (42) is in the shape of a line in a left-right direction (X), and said line (42) intersects the emitter axis (A1) at said rear focal point (421).

5. The lens device (100) according to claim 4, **characterized in that** each of said first and second focal regions (311, 521) is in the form of a point, and fully overlaps with said rear focal point (421).

## Patentansprüche

1. Linsenvorrichtung (100) zum Lenken von Lichtstrahlen von einem Lichtemitter (2), der eine Emitterachse (A1) in einer Vorwärts-Rückwärts-Richtung (Z) hat, wobei die Linsenvorrichtung (100) wenigstens eine optische Linse (10) aufweist, die enthält
ein hinteres Linsensegment (3) mit
einer Aussparung (331), die sich von einem hinteren Ende (30) des hinteren Linsensegments (3) entlang der Emitterachse (A1) nach vorne erstreckt, um an einer ersten Brechungsfläche (31) zu enden, wobei die Aussparung (331) eine zweite Brechungsfläche (33) hat, die sich in der Vorwärts-Rückwärts-Richtung (Z) erstreckt, um das hintere Ende (30) und die erste Brechungsfläche (31) miteinander zu verbinden, und die sich in Umfangsrichtung erstreckt, um die Emitterachse (A1) zu umgeben, und
einer Reflektierfläche (32), die von einem Außenumfang des hinteren Endes (30) nach vorne divergiert, um die Emitterachse (A1) zu umgeben und eine Außenumfangsfläche des hinteren Linsensegments (3) zu bilden; und
ein vorderes Linsensegment (4), das sich vom hinteren Linsensegment (3) entlang der Emitterachse (A1) nach vorne erstreckt, um an einer konvexen Linsenfront (41) zu enden, die einen hinteren Brennbereich (42) definiert, der sich hinter dem hinteren Linsensegment (3) befindet,
die erste Brechungsfläche (31) so konfiguriert ist, dass, wenn die Lichtstrahlen vom Lichtemitter (2) durch die erste Brechungsfläche (31) in die optische Linse (10) eintreten, um mehrere von ersten gebrochenen Lichtstrahlen (B1) in der optischen Linse (10) zu bilden, mehrere erste imaginäre Linien (L1), die sich nach hinten und jeweils von den ersten gebrochenen Lichtstrahlen (B1) erstrecken, in einem ersten Brennpunkt (311) konvergieren;
die zweite Brechungsfläche (33) und die Reflektierfläche (32) so konfiguriert sind, dass, wenn die Lichtstrahlen vom Lichtemitter (2) durch die zweite Brechungsfläche (33) in die optische Linse (10) eintreten und dann von der Reflektierfläche (32) reflektiert werden, um mehrere reflektierte Lichtstrahlen (RB) zu bilden, mehrere zweite imaginäre Linien (L2), die sich nach hinten und jeweils von den reflektierten Lichtstrahlen (RB) erstrecken, in einem zweiten Brennpunktbereich (521) konvergieren, der mit dem hinteren Brennpunktbereich (42) überlappt;
der erste Brennpunktbereich (311) mit dem hinteren Brennpunktbereich (42) überlappt;
der hintere Brennpunktbereich (42) einen hinteren Brennpunkt (421) auf der Emitterachse (A1) hat;
die zweite Brechungsfläche (33) einen ausgewählten Bereich (330) so hat, dass, wenn die Lichtstrahlen vom Lichtemitter (2) durch den ausgewählten Bereich (330) der zweiten Brechungsfläche (33) in die optische Linse (10) eintreten, um mehrere zweite gebrochene Lichtstrahlen (B2) in der optischen Linse (10) zu bilden, mehrere dritten imaginären Linien (L3), die sich nach hinten und jeweils von den zweiten gebrochenen Lichtstrahlen (B2) erstrecken, in einem dritten Brennpunkt (321) konvergieren;
der dritte Brennpunkt (321) und der hintere Brennpunkt (421) des hinteren Brennpunktbereichs (42) zusammen eine Hyperbel (5) definieren, die einen distalen Zweig (52) und einen proximalen Zweig (51) relativ zu dem dritten Brennpunkt (321) hat, wobei der proximale Zweig (51) einen distalen Arm (510) und einen proximalen Arm (511) relativ zum ausgewählten Bereich (330) der zweiten Brechungsfläche (33) hat; und
**dadurch gekennzeichnet, dass** die Reflektierfläche (32) durch Drehen des proximalen Arms (511) um die Emitterachse (A1) gebildet wird.

2. Linsenvorrichtung (100) nach Anspruch 1, **dadurch gekennzeichnet, dass** die konvexe Linsenvorderseite (41) eine kuppelförmige konvexe Oberfläche ist, sodass der hintere Brennpunktbereich (42) in der Form eines Punktes oder einer Kugel am hinteren Brennpunkt (421) ist.

3. Linsenvorrichtung (100) nach Anspruch 2, **dadurch gekennzeichnet, dass** jeder der ersten und zweiten Brennpunktbereiche (311, 521) in der Form eines Punktes ist und sich vollständig mit dem hinteren Brennpunkt (421) überlappt.

4. Linsenvorrichtung (100) nach Anspruch 1, **dadurch gekennzeichnet, dass** die konvexe Linsenvorderseite (41) eine bogenförmige konvexe Oberfläche ist, sodass der hintere Brennpunktbereich (42) in der Form einer Linie in einer Links-Rechts-Richtung (X) ist, und die Linie (42) die Emitterachse (A1) am hinteren Brennpunkt (421) schneidet.

5. Linsenvorrichtung (100) nach Anspruch 4, **dadurch gekennzeichnet, dass** jeder der ersten und zweiten Brennpunktbereiche (311, 521) in der Form eines Punktes ist und sich vollständig mit dem hinteren Brennpunkt (421) überlappt.

## Revendications

1. Dispositif de lentille (100) destiné à diriger des faisceaux lumineux issus d'un émetteur de lumière (2) qui a un axe d'émetteur (A1) dans une direction avant-arrière (Z), ledit dispositif de lentille (100) comprenant au moins une lentille optique (10) qui inclut :
un segment de lentille arrière (3) ayant :
un renfoncement (331) s'étendant vers l'avant depuis une extrémité arrière (30) dudit segment de lentille arrière (3) le long de l'axe d'émetteur (A1) pour se terminer au niveau d'une première surface de réfraction (31), ledit renfoncement (331) ayant une deuxième surface de réfraction (33) qui s'étend dans la direction avant-arrière (Z) pour interconnecter ladite extrémité arrière (30) et ladite première surface de réfraction (31), et qui s'étend circonférentiellement pour entourer l'axe d'émetteur (A1), et
une surface de réflexion (32) divergeant vers l'avant depuis une périphérie externe de ladite extrémité arrière (30) pour entourer l'axe d'émetteur (A1) et pour former une surface périphérique externe dudit segment de lentille arrière (3) ; et
un segment de lentille avant (4) s'étendant vers l'avant depuis ledit segment de lentille arrière (3) le long de l'axe d'émetteur (A1) pour se terminer au niveau d'une partie avant convexe de lentille (41) qui définit une région focale arrière (42) qui est située à l'arrière dudit segment de lentille arrière (3),
dans lequel ladite première surface de réfraction (31) est configurée de telle sorte que, lorsque les faisceaux lumineux issus de l'émetteur de lumière (2) pénètrent dans ladite lentille optique (10) à travers ladite première surface de réfraction (31) pour former une pluralité de premiers faisceaux lumineux réfractés (B1) dans ladite lentille optique (10), une pluralité de premières lignes imaginaires (L1), qui s'étendent vers l'arrière et respectivement depuis des premiers faisceaux lumineux réfractés (B1), convergent au niveau d'une première région focale (311),
dans lequel ladite deuxième surface de réfraction (33) et ladite surface de réflexion (32) sont configurées de telle sorte que, lorsque les faisceaux lumineux issus de l'émetteur de lumière (2) pénètrent dans ladite lentille optique (10) à travers ladite deuxième surface de réfraction (33) et sont ensuite réfléchis par ladite surface de réflexion (32) pour former une pluralité de faisceaux lumineux réfléchis (RB), une pluralité de deuxièmes lignes imaginaires (L2), qui s'étendent vers l'arrière et respectivement depuis des faisceaux lumineux réfléchis (RB), convergent au niveau d'une deuxième région focale (521) chevauchant ladite région focale arrière (42),
dans lequel ladite première région focale (311) chevauche ladite région focale arrière (42),
dans lequel ladite région focale arrière (42) a un point focal arrière (421) sur l'axe d'émetteur (A1),
dans lequel ladite deuxième surface de réfraction (33) a une région sélectionnée (330) de telle sorte que, lorsque les faisceaux lumineux issus de l'émetteur de lumière (2) pénètrent dans ladite lentille optique (10) à travers ladite région sélectionnée (330) de ladite deuxième surface de réfraction (33) pour former une pluralité de deuxièmes faisceaux lumineux réfractés (B2) dans ladite lentille optique (10), une pluralité de troisièmes lignes imaginaires (L3), qui s'étendent vers l'arrière et respectivement depuis des deuxièmes faisceaux lumineux réfractés (B2), convergent au niveau d'un troisième point focal (321),
dans lequel ledit troisième point focal (321) et ledit point focal arrière (421) de ladite région focale arrière (42) définissent en coopération une hyperbole (5) qui a une branche distale (52) et une branche proximale (51) par rapport audit troisième point focal (321), la branche proximale (51) ayant un bras distal (510) et un bras proximal (511) par rapport à ladite région sélectionnée (330) de ladite deuxième surface de réfraction (33), et
**caractérisé en ce que** ladite surface de réflexion (32) est formée en faisant tourner le bras proximal (511) autour de l'axe d'émetteur (A1).

2. Dispositif de lentille (100) selon la revendication 1, **caractérisé en ce que** ladite partie avant convexe de lentille (41) est une surface convexe en forme de dôme de telle sorte que ladite région focale arrière (42) a la forme d'un point ou d'une boule au niveau du point focal arrière (421).

3. Dispositif de lentille (100) selon la revendication 2, **caractérisé en ce que** chacune desdites première et deuxième régions focales (311, 521) se présente sous la forme d'un point et chevauche entièrement ledit point focal arrière (421).

4. Dispositif de lentille (100) selon la revendication 1, **caractérisé en ce que** ladite partie avant convexe de lentille (41) est une surface convexe en forme d'arc de telle sorte que ladite région focale arrière (42) a la forme d'une ligne dans une direction gauche-droite (X), et ladite ligne (42) coupe l'axe d'émetteur (A1) au niveau dudit point focal arrière (421).

5. Dispositif de lentille (100) selon la revendication 4, **caractérisé en ce que** chacune desdites première et deuxième régions focales (311, 521) se présente sous la forme d'un point et chevauche entièrement ledit point focal arrière (421).
